# DEMANDE DE BREVET EUROPEEN

(11) **EP 3 584 914 A1**
(43) Date de publication de la demande: **25.12.2019**
(21) Numéro de dépôt: 19180310.5
(22) Date de dépôt: 14.06.2019
(51) Int. Cl.: H02M 1/08, H02M 7/5387, H03K 17/08, H02M 1/32, H02M 1/00

(54) **CONVERTISSEUR D'ÉNERGIE ÉLECTRIQUE, CHAÎNE DE TRACTION COMPORTANT UN TEL CONVERTISSEUR ET VÉHICULE ÉLECTRIQUE DE TRANSPORT ASSOCIÉ**

(30) Priorité: 19.06.2018 FR 1855367
(71) Demandeur: ALSTOM Transport Technologies, 93400 Saint-Ouen (FR)
(72) Inventeur: LEPAGE, Jean-Pierre, 65800 AUREILHAN (FR)
(74) Mandataire: Lavoix

(57) **Abrégé**

Ce convertisseur d'énergie électrique comprend deux premières bornes ; au moins une deuxième borne ; au moins un bras de commutation comportant deux demi-bras connectés en série entre les deux premières bornes et reliés en un point intermédiaire connecté à une deuxième borne respective, chaque demi-bras comprenant au moins un interrupteur comportant au moins un transistor de puissance (66) ; et deux modules de commande configurés pour commander les interrupteurs d'un demi-bras respectif et comportant chacun un étage de commande (80) connecté à une électrode de grille (72) de chaque transistor de puissance.

L'étage de commande comporte un ensemble (86) de transistors (88) de commande du transistor de puissance parmi un mode passant et un mode bloqué, ledit ensemble comportant un transistor principal (100) relié à l'électrode de grille du transistor de puissance et au moins un transistor secondaire (102) relié à une électrode de grille du transistor principal.

## Description

La présente invention concerne un convertisseur d'énergie électrique configuré pour convertir une première énergie électrique en une deuxième énergie électrique.

L'invention concerne également une chaîne de traction pour un véhicule électrique de transport, la chaîne de traction comprenant un moteur électrique et un tel convertisseur d'énergie électrique, relié au moteur électrique.

L'invention concerne également un véhicule électrique de transport, tel qu'un véhicule ferroviaire, comprenant une telle chaîne de traction, configurée pour provoquer un déplacement du véhicule.

Le convertisseur d'énergie électrique comprend deux premières bornes associées à la première énergie électrique, au moins une deuxième borne associée à la deuxième énergie électrique, et au moins un bras de commutation, chaque bras de commutation comportant deux demi-bras de commutation connectés en série entre les deux premières bornes et reliés entre eux en un point intermédiaire, le point intermédiaire étant relié à une deuxième borne respective. Chaque demi-bras de commutation comporte au moins un interrupteur, chaque interrupteur comportant au moins un transistor de puissance réalisé en carbure de silicium. Le convertisseur d'énergie électrique comprend deux modules de commande, chaque module de commande étant configuré pour commander le ou les interrupteurs d'un demi-bras de commutation respectif, chaque module de commande comportant un étage de commande connecté à une électrode de grille de chaque transistor de puissance compris dans le demi-bras de commutation correspondant.

L'invention s'applique au domaine du transport, en particulier du transport ferroviaire, notamment aux véhicules de traction électriques, tels que les locomotives et les automotrices.

L'invention concerne le domaine des convertisseurs d'énergie électrique comprenant pour la conversion de l'énergie électrique des transistors de puissance réalisés en carbure de silicium, également appelés transistors SiC (de l'anglais *Silicon Carbide*)*.*

On connait du document US 2013/0039100 A1 un convertisseur d'énergie électrique du type précité. Le convertisseur d'énergie électrique est un onduleur apte à convertir une énergie continue en une énergie alternative triphasée pour alimenter un moteur électrique triphasé.

Le convertisseur d'énergie électrique comprend deux premières bornes associées à l'énergie continue, trois deuxièmes bornes associées à l'énergie alternative triphasée, et trois bras de commutation, chaque bras de commutation comportant deux demi-bras de commutation connectés en série entre les deux premières bornes et reliés entre eux en un point intermédiaire, le point intermédiaire étant relié à une deuxième borne respective.

Chaque demi-bras de commutation comporte deux demi-branches de commutation connectées en parallèle, ou respectivement trois demi-branches de commutation suivant le mode de réalisation considéré, chaque demi-branche de commutation comportant un interrupteur formé d'un transistor et d'une diode connectée en antiparallèle du transistor.

Le convertisseur d'énergie électrique comprend en outre une unité de commande des trois bras de commutation, l'unité de commande étant configurée pour déphaser la commutation d'un bras par rapport à l'autre, afin de délivrer l'énergie alternative triphasée en sortie du convertisseur d'énergie électrique.

Toutefois, les commutations des bras de commutation ne sont pas toujours optimales.

La présente invention a donc pour but de proposer un convertisseur d'énergie électrique permettant d'améliorer la commutation au sein de chaque bras de commutation, en limitant la consommation d'énergie électrique pour cette commutation.

A cet effet, l'invention a pour objet un convertisseur d'énergie électrique du type précité, dans lequel le ou chaque étage de commande comporte un ensemble de transistors de commande configuré pour commander le ou au moins l'un des transistors de puissance auquel l'étage de commande est connecté parmi un mode passant et un mode bloqué, l'ensemble de transistors de commande comportant un transistor principal de commande relié à l'électrode de grille du transistor de puissance et au moins un transistor secondaire de commande relié à une électrode de grille du transistor principal de commande, au moins un transistor de l'ensemble de transistors de commande étant un transistor à effet de champ à grille isolée.

Avec le convertisseur d'énergie électrique selon l'invention, l'ensemble de transistors de commande comportant au moins un transistor à effet de champ à grille isolée, également appelé MOSFET (de l'anglais *Metal Oxide Semiconductor Field Effect Transistor*), permet de ne pas exiger une consommation permanente de courant pour se maintenir dans un état donné. La commande pour la commutation du transistor SiC de puissance est alors assimilable à une commande impulsionnelle, faiblement consommatrice de courant. L'étage de commande à base de technologie MOS permet alors de limiter la consommation d'énergie électrique pour la commutation du transistor SiC de puissance, contrairement aux technologies nécessitant une source de courant, comme la technologie à base de transistors bipolaires par exemple.

En outre, l'ensemble de transistors de commande, avec un transistor principal de commande relié à une électrode de grille du transistor de puissance et au moins un transistor secondaire de commande relié à une électrode de grille du transistor principal de commande, permet de limiter encore la consommation d'énergie électrique pour la commutation du transistor SiC de puissance, en autorisant de commuter plus rapidement le transistor principal de commande.

En complément, l'homme du métier observera qu'en matière de consommation électrique d'un tel convertisseur d'énergie électrique, deux consommations électriques sont à prendre en considération. Une première consommation électrique est la consommation de chaque bras de commutation lors de sa commutation, dont l'ordre de grandeur exprimé en RMS est en général au-dessus du kW. Une deuxième consommation électrique est la consommation du module de commande lui-même, également appelé allumeur, qui est quant à elle généralement inférieure à 5W au global, ce qui est sans commune mesure avec la première consommation électrique. Mais ce n'en n'est pas moins important, car cela dimensionne l'alimentation du module de commande. Le convertisseur d'énergie électrique selon l'invention permet alors de réduire chacune de ces première et deuxième consommations électriques.

Suivant d'autres aspects avantageux de l'invention, le convertisseur d'énergie électrique comporte l'une ou plusieurs des caractéristiques suivantes, prises isolément ou suivant toutes les combinaisons techniquement possibles :
- l'ensemble de transistors de commande est constitué de transistors à effet de champ à grille isolée ;
- l'ensemble de transistors de commande comporte un premier sous-ensemble de transistors pour la génération d'un signal de commande du transistor de puissance en mode passant et un deuxième sous-ensemble de transistors pour la génération d'un signal de commande du transistor de puissance en mode bloqué,
   chaque sous-ensemble de transistors comportant un transistor principal de commande relié à une électrode de grille du transistor de puissance et au moins un transistor secondaire de commande relié à une électrode de grille du transistor principal de commande ;
- l'étage de commande comporte en outre des première et deuxième impédances, la deuxième impédance étant distincte de la première impédance et de valeur supérieure à celle de la première impédance, et l'ensemble de transistors de commande est configuré pour commuter entre une première configuration d'extinction du transistor de puissance dans laquelle un courant issu de l'électrode de grille du transistor de puissance circule à travers la première impédance lors de la commande du transistor de puissance en mode bloqué et une deuxième configuration d'extinction du transistor de puissance dans laquelle un courant issu de l'électrode de grille du transistor de puissance circule à travers la deuxième impédance lors de la commande du transistor de puissance en mode bloqué ;
- chaque module de commande comporte une unité de pilotage configurée pour piloter l'étage de commande,
   l'unité de pilotage étant de préférence réalisée sous forme d'un composant logique programmable, tel qu'un FPGA ;
- chaque interrupteur est un interrupteur bidirectionnel comportant une diode connectée en antiparallèle de chaque transistor de puissance, chaque transistor de puissance étant réalisé en carbure de silicium ;
- chaque demi-bras de commutation comporte N demi-branches de commutation connectées en parallèle, N étant un nombre entier supérieur ou égal à 2, chaque demi-branche de commutation comportant au moins un interrupteur ; et
- le convertisseur d'énergie électrique comprend P bras de commutation et 2xP modules de commande, P étant un nombre entier supérieur ou égal à 2, de préférence égal à 3.

L'invention a également pour objet une chaîne de traction pour un véhicule électrique de transport, la chaîne de traction comprenant un moteur électrique et un convertisseur d'énergie électrique relié au moteur électrique, le convertisseur d'énergie électrique étant tel que défini ci-dessus.

L'invention a également pour objet un véhicule électrique de transport, tel qu'un véhicule ferroviaire, comprenant une chaîne de traction configurée pour provoquer un déplacement du véhicule, la chaîne de traction étant telle que définie ci-dessus.

Ces caractéristiques et avantages de l'invention apparaîtront à la lecture de la description qui va suivre, donnée uniquement à titre d'exemple non limitatif, et faite en référence aux dessins annexés, sur lesquels :

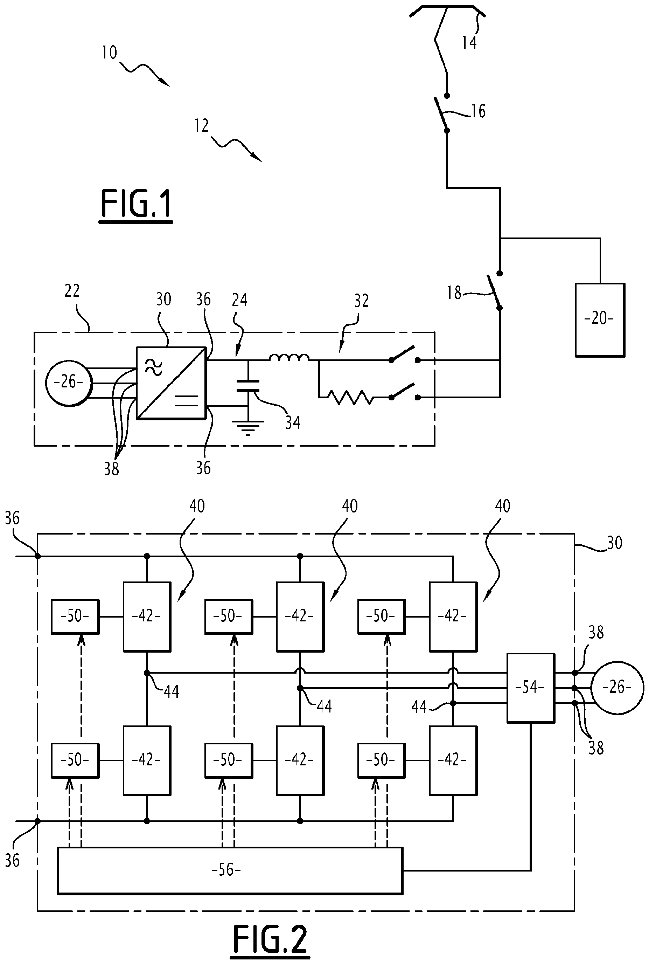

- la figure 1 est une représentation schématique d'un véhicule électrique de transport, tel qu'un véhicule ferroviaire, comprenant une chaîne de traction, la chaîne de traction comportant un moteur électrique et un convertisseur d'énergie électrique relié au moteur électrique ;
- la figure 2 est une représentation schématique du convertisseur d'énergie électrique de la figure 1, le convertisseur étant configuré pour convertir une première énergie électrique en une deuxième énergie électrique, et comprenant deux premières bornes associées à la première énergie électrique, trois deuxièmes bornes associées à la deuxième énergie électrique, et trois bras de commutation connectés en parallèle entre les deux premières bornes ;

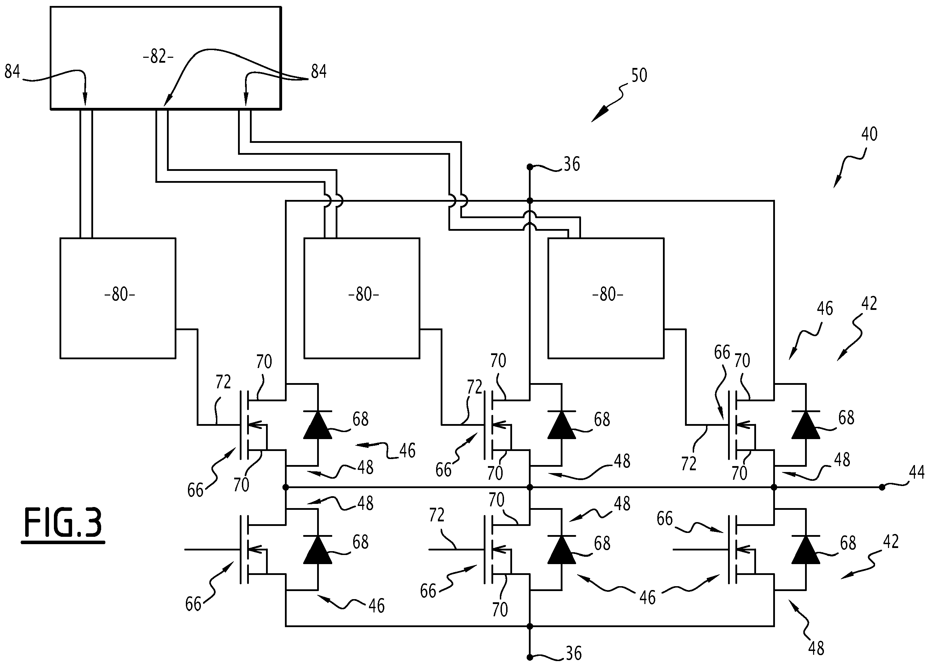

- la figure 3 est une représentation schématique de l'un des bras de commutation de la figure 2 et d'un module de commande, le bras de commutation comportant deux demi-bras de commutation connectés en série entre les deux premières bornes et reliés entre eux en un point intermédiaire connecté à une deuxième borne respective, le module de commande étant configuré pour commander un ou des interrupteurs d'un demi-bras respectif, chaque interrupteur comportant au moins un transistor de puissance, le module de commande comportant un étage de commande connecté à une électrode de grille de chaque transistor de puissance ;

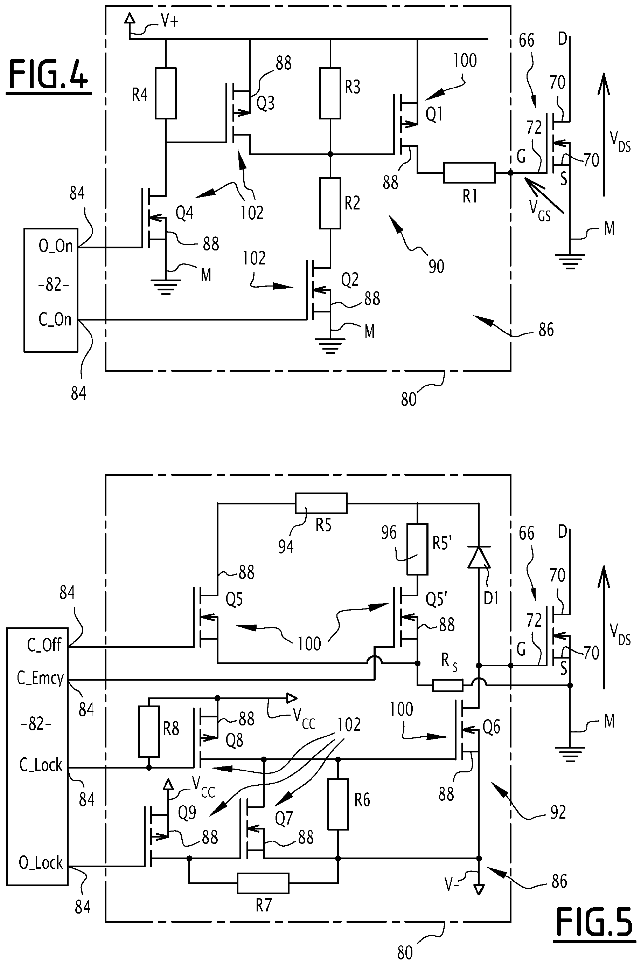

- la figure 4 est une représentation schématique du module de commande de la figure 3, où seule une partie de l'étage de commande est représentée, la partie représentée étant celle dédiée à la commande du transistor de puissance en mode passant, l'autre partie de l'étage de commande, dédiée à la commande du transistor de puissance en mode bloqué, étant représentée sur la figure 5 et n'étant pas représentée sur cette figure par souci de simplification du dessin ;
- la figure 5 est une vue analogue à celle de la figure 4, où seule une partie de l'étage de commande est représentée, la partie représentée étant celle dédiée à la commande du transistor de puissance en mode bloqué, l'autre partie de l'étage de commande, dédiée à la commande du transistor de puissance en mode passant, étant représentée sur la figure 4 et n'étant pas représentée sur cette figure par souci de simplification du dessin ;

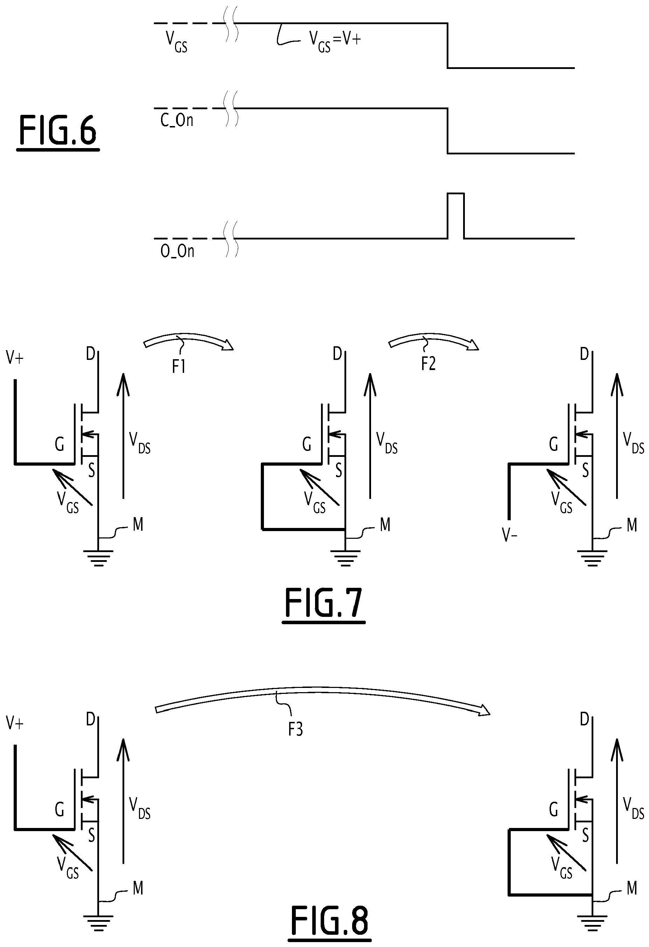

- la figure 6 est une représentation schématique de chronogrammes lors de la commande du transistor de puissance en mode passant ;
- la figure 7 est une représentation schématique de la circulation du courant en l'électrode de grille du transistor de puissance lors de sa commutation du mode passant vers le mode bloqué, en cas de fonctionnement normal du transistor de puissance ; et
- la figure 8 est une vue analogue à celle de la figure 7, en cas de défaut du transistor de puissance.

Dans la suite de la description, l'expression « sensiblement égal à » définit une relation d'égalité à plus ou moins 10%, de préférence encore une relation d'égalité à plus ou moins 5%.

Sur la figure 1, un véhicule électrique de transport 10, tel qu'un véhicule ferroviaire, comprend une chaîne de traction 12, la chaîne de traction 12 comportant un pantographe 14 apte à être connecté à une caténaire, non représentée.

La chaîne de traction 12 comprend un commutateur électrique 16 connecté au pantographe 14 et un disjoncteur électrique 18 connecté au commutateur électrique 16. La chaîne de traction 12 comprend, en complément facultatif, un équipement auxiliaire 20 connecté entre le commutateur électrique 16 et le disjoncteur électrique 18, en dérivation par rapport au disjoncteur électrique 18.

Le commutateur électrique 16, le disjoncteur électrique 18 et l'équipement auxiliaire 20 sont connus en soi, et ne sont pas décrits plus en détail. L'équipement auxiliaire 20 est par exemple un convertisseur statique.

Un ensemble de traction 22 est connecté au disjoncteur électrique 18 via un bus continu 24. L'ensemble de traction 22 comporte un moteur électrique 26, un convertisseur d'énergie électrique 30 relié au moteur électrique 26. Dans l'exemple de la figure 1, le convertisseur d'énergie électrique 30 est destiné à délivrer une tension alternative au moteur 26 à partir d'une tension continue issue du bus continu 24.

En complément, l'ensemble de traction 22 comporte un dispositif de filtrage 32, comportant notamment un condensateur de filtrage 34.

En complément facultatif, l'ensemble de traction 22 comporte un appareil de stockage d'énergie électrique, non représenté, l'appareil de stockage d'énergie électrique étant également appelé coffre d'autonomie, et servant, d'une part, de source d'alimentation auxiliaire, et d'autre part, à récupérer de l'énergie électrique lors d'un freinage du véhicule électrique de transport 10. L'appareil de stockage d'énergie électrique est par exemple connecté en dérivation, entre le disjoncteur électrique 18 et le condensateur de filtrage 34.

Le moteur électrique 26 est par exemple un moteur alternatif, tel qu'un moteur triphasé.

Le convertisseur d'énergie électrique 30 est configuré pour convertir une première énergie électrique en une deuxième énergie électrique.

Dans l'exemple de la figure 2, le convertisseur d'énergie électrique 30 est configuré pour convertir une énergie continue associée au bus continu 24 en une énergie alternative, telle qu'une énergie triphasée, associée au moteur électrique 26. La première énergie électrique est alors l'énergie continue, et la deuxième énergie électrique est l'énergie alternative, telle que l'énergie triphasée.

Le convertisseur d'énergie électrique 30 comprend deux premières bornes 36 associées à la première énergie électrique, au moins une deuxième borne 38 associée à la deuxième énergie électrique, et P bras de commutation 40, P étant un nombre entier supérieur ou égal à 1.

Dans l'exemple de la figure 2, le convertisseur d'énergie électrique 30 est un convertisseur d'énergie continue en énergie alternative triphasée, et comprend alors trois deuxièmes bornes 38 et trois bras de commutation 40, à savoir une deuxième borne 38 et un bras de commutation 40 pour chaque phase de l'énergie triphasée. Autrement dit, le nombre P de bras de commutation 40 est ici égal à 3.

Chaque bras de commutation 40 comporte deux demi-bras de commutation 42 connectés en série entre les deux premières bornes 36 et reliés entre eux en un point intermédiaire 44, le point intermédiaire 44 étant relié à une deuxième borne 38 respective.

Chaque demi-bras de commutation 42 comporte N demi-branches de commutation 46 connectées en parallèle, N étant un nombre entier supérieur ou égal à 2, chaque demi-branche de commutation 46 comportant au moins un interrupteur 48, comme représenté sur la figure 3. Chaque demi-bras de commutation 42 comporte alors au moins N interrupteurs 48.

Dans l'exemple de la figure 3, chaque demi-bras de commutation 42 comporte trois demi-branches de commutation 46 en parallèle, et le nombre N est alors égal à 3.

Le convertisseur d'énergie électrique 30 comprend en outre 2xP modules de commande 50, chaque module de commande 50 étant configuré pour commander les interrupteurs 48 d'un demi-bras de commutation 42 respectif, comme représenté sur la figure 2. Dans l'exemple de la figure 2, le convertisseur d'énergie électrique 30 comprend alors six modules de commande 50, P étant ici égal à 3, avec un module de commande 50 respectif pour chaque demi-bras de commutation 42.

Le convertisseur d'énergie électrique 30 comprend un dispositif de mesure 54, visible sur la figure 2, configuré pour mesurer au moins une grandeur électrique relative à la deuxième énergie électrique, et un dispositif de pilotage 56 configuré pour piloter les différents modules de commande 50, notamment en fonction de la ou des grandeurs mesurées par le dispositif de mesure 54.

Dans l'exemple de la figure 3, chaque demi-branche de commutation 46 comporte un seul interrupteur 48.

En variante non représentée, chaque demi-branche de commutation 46 comporte plusieurs interrupteurs 48 connectés en série entre la deuxième borne 36 correspondante et le point intermédiaire 44 respectif. Ceci permet alors de convertir une énergie électrique de tension plus élevée.

Au moins un interrupteur 48 est, par exemple, un interrupteur bidirectionnel. Chaque interrupteur 48 est de préférence un interrupteur bidirectionnel.

Lorsque tous les interrupteurs 48 sont bidirectionnels, le convertisseur d'énergie électrique 30 est alors un convertisseur bidirectionnel configuré pour convertir la première énergie électrique en la deuxième énergie électrique si le courant circule depuis des premières bornes 36 vers la ou les deuxièmes bornes 38, et inversement configuré pour convertir la deuxième énergie électrique en la première énergie électrique si le courant circule depuis la ou les deuxièmes bornes 38 vers les premières bornes 36.

Ce fonctionnement du convertisseur d'énergie électrique 30 en inverse pour convertir la deuxième énergie électrique en la première énergie électrique est notamment utile pour récupérer de l'énergie lors d'un freinage du véhicule électrique de transport 10.

Chaque interrupteur bidirectionnel 48 comporte, par exemple, un transistor de puissance 66 et une diode 68 connectée en antiparallèle du transistor de puissance 66. Comme connu en soi, chaque transistor de puissance 66 comporte deux électrodes de conduction 70 et une électrode de commande 72, chaque transistor de puissance 66 étant commandable, via son électrode de commande 72, entre un état parmi un état passant dans lequel le courant circule entre les électrodes de conduction 70, et un état bloqué dans lequel le courant ne circule pas entre les électrodes de conduction 70. La diode 68 est alors connectée entre les électrodes de conduction 70.

Chaque interrupteur 48 comporte au moins un transistor de puissance 66 réalisé en carbure de silicium, également noté SiC (de l'anglais *Silicon Carbide*), et les électrodes de conduction 70 sont respectivement appelées électrode de source, également notée S sur les figures 4 à 7, et électrode de drain, également notée D sur les figures 4 et 6 à 7, l'électrode de commande 72 étant alors appelée électrode de grille, également notée G sur les figures 4 à 7. Chaque transistor de puissance 66 est de préférence réalisé en carbure de silicium.

Chaque module de commande 50 comporte un étage de commande 80 connecté à l'électrode de grille G de chaque transistor de puissance 66. Le module de commande 50 comprend un étage de commande 80 respectif pour chaque interrupteur 48, comme représenté sur la figure 3.

Chaque module de commande 50 comporte une unité de pilotage 82 configurée pour piloter chaque étage de commande 80. L'unité de pilotage 82 comporte des bornes de sortie 84 pour chaque interrupteur 48 respectif, chaque borne de sortie 84 étant configurée pour délivrer un signal de commande respectif à l'étage de commande 80.

En complément facultatif, au moins un module de commande 50 est, par exemple, configuré en outre pour synchroniser les commutations des interrupteurs 48 d'un demi-bras de commutation 42 respectif. Chaque module de commande 50 est de préférence configuré pour synchroniser les commutations des interrupteurs 48 du demi-bras de commutation 42 auquel il est associé.

Selon ce complément facultatif, chaque module de commande 50 qui est apte à synchroniser les commutations des interrupteurs 48 d'un demi-bras de commutation 42 respectif est configuré pour piloter la délivrance des signaux de commandes desdits interrupteurs 48 en fonction de délais de commutation prédéfinis, un délai de commutation prédéfini étant associé à chacun des interrupteurs 48 dudit demi-bras de commutation 42. Autrement dit, chaque unité de pilotage 82 est alors propre à délivrer les signaux de commande à l'étage de commande 80 respectif, ceci de manière décalée d'un étage de commande 80 à l'autre, en fonction des caractéristiques des interrupteurs 48, en particulier en fonction des délais de commutations prédéfinis qui leur sont associés.

L'homme du métier comprendra alors que chaque module de commande 50 vise à retarder la commutation de l'interrupteur 48 ayant tendance à commuter le plus vite parmi les différents interrupteurs 48 du demi-bras de commutation 42 concerné, et au contraire à commander au plus tôt la commutation de l'interrupteur 48 ayant tendance à commuter le plus lentement parmi lesdits différents interrupteurs 48 de ce demi-bras de commutation 42.

Ces délais de commutation prédéfinis sont par exemple déterminés au cours de tests préliminaires effectués sur les interrupteurs 48, en particulier sur les transistors de puissance 66. En effet, ces délais ou temps de commutation sont propres à chaque interrupteur 48, et en particulier à chaque transistor de puissance 66, puisqu'ils dépendent de caractéristiques intrinsèques de ces composants, variables d'un composant à l'autre, en particulier d'un transistor de puissance 66 à l'autre, et résultant de la fabrication.

L'homme du métier observera que sur la figure 3, seuls l'unité de pilotage 82 et les étages de commande 80 associés à l'un des deux demi-bras de commutation 42 du bras de commutation 40 considéré sont représentés par souci de simplification du dessin, l'unité de pilotage 82 et les étages de commande 80 représentés étant ceux associés au demi-bras de commutation 42 supérieur. L'unité de pilotage 82 et les étages de commande 80 associés au demi-bras de commutation 42 inférieur ne sont donc pas représentés sur la figure 3.

Le dispositif de mesure 54 est configuré pour mesurer par exemple l'intensité de chaque courant circulant à travers une deuxième borne 38 respective et/ou la tension en cette deuxième borne 38, c'est-à-dire le courant traversant le deuxième point intermédiaire 44 correspondant et/ou la tension en ce deuxième point intermédiaire 44.

Le dispositif de pilotage 56 est configuré pour piloter les différents modules de commande 50, et ainsi pour commander les différents demi-bras de commutation 42 afin d'effectuer la conversion d'énergie. Le pilotage des modules de commande 50 est notamment effectué en fonction de la ou des grandeurs mesurées par le dispositif de mesure 54.

Chaque étage de commande 80 est connecté entre les bornes de sortie 84 et l'interrupteur 48 correspondant, et comporte un ensemble 86 de transistors de commande 88 configuré pour commander le transistor de puissance 66 parmi un mode passant et un mode bloqué. L'ensemble 86 de transistors de commande 88 comporte un premier sous-ensemble de transistors 90 pour la génération d'un signal de commande du transistor de puissance 66 en mode passant, comme représenté sur la figure 4, et un deuxième sous-ensemble de transistors 92 pour la génération d'un signal de commande du transistor de puissance 66 en mode bloqué, comme représenté sur la figure 5.

Chaque étage de commande 80 comporte en outre des première 94 et deuxième 96 impédances, visibles sur la figure 5, la deuxième impédance 96 étant distincte de la première impédance 94 et de valeur supérieure à celle de la première impédance 94. L'ensemble 86 de transistors de commande 88 est alors configuré pour être commandé, suivant la valeur de la tension V_{DS}, dans une configuration parmi deux configurations distinctes possibles, à savoir une première configuration d'extinction du transistor de puissance 66 dans laquelle un courant issu de l'électrode de grille G du transistor de puissance 66 circule à travers la première impédance 94 lors de la commande du transistor de puissance en mode bloqué et une deuxième configuration d'extinction du transistor de puissance 66 dans laquelle un courant issu de l'électrode de grille G du transistor de puissance 66 circule à travers la deuxième impédance 96 lors de la commande du transistor de puissance en mode bloqué. Le deuxième sous-ensemble de transistors 92 dédié à la génération du signal de commande du transistor de puissance 66 en mode bloqué est plus particulièrement configuré pour commuter entre les première et deuxième configurations d'extinction du transistor de puissance 66.

L'unité de pilotage 82 est, par exemple, réalisée sous forme d'un composant logique programmable, tel qu'un FPGA (de l'anglais *Field-Programmable Gate Array*). Le convertisseur d'énergie électrique 30 comprend, par exemple, 2xP composants logiques programmables, chacun formant une unité de pilotage 82 respective. En variante, au moins deux unités de pilotage 82 sont réalisées sur un seul composant logique programmable, tout en étant distincts avec des bornes de sortie 84 spécifiques pour chaque étage de commande 80.

L'ensemble 86 de transistors de commande 88 comporte un transistor principal de commande 100 relié à l'électrode de grille G du transistor de puissance 66 et au moins un transistor secondaire de commande 102 relié à une électrode de grille du transistor principal de commande 100. Par exemple, chaque sous-ensemble de transistors 90, 92 comporte un transistor principal de commande 100 respectif relié à l'électrode de grille G du transistor de puissance 66 et au moins un transistor secondaire de commande 102 relié à l'électrode de grille du transistor principal de commande 100.

Dans l'exemple de la figure 4, pour la génération du signal de commande du transistor de puissance 66 en mode passant, le premier sous-ensemble de transistors 90 comporte un seul transistor principal de commande 100, à savoir le transistor Q1 dont l'électrode de drain est reliée à l'électrode de grille G du transistor de puissance 66 via une résistance R1, et trois transistors secondaires de commande 102, à savoir les transistors Q2, Q3 et Q4, l'électrode de drain du transistor Q2 étant reliée à l'électrode de grille du transistor principal de commande 100, à savoir le transistor Q1, via une résistance R2 et l'électrode de drain du transistor Q3 étant directement connectée à l'électrode de grille du transistor Q1. L'électrode de drain du transistor Q4 est quant à elle directement connectée à l'électrode de grille du transistor Q3.

Dans l'exemple de la figure 4, pour la génération du signal de commande du transistor de puissance 66 en mode passant, l'étage de commande 80 comporte en outre une résistance R3 connectée entre les électrodes de grille et de source du transistor Q1 et une résistance R4 connectée entre les électrodes de grille et de source du transistor Q3. L'électrode de source de chacun des transistors Q1 et Q3 est connectée à un potentiel positif, noté V+, par exemple sensiblement égal à +20V. L'électrode de grille du transistor Q2 est connectée à une borne de sortie 84 de l'unité de pilotage 82, cette borne de sortie étant notée C_On (de l'anglais *Close_On*), et l'électrode de grille du transistor Q4 est connectée à une autre borne de sortie 84 de l'unité de pilotage 82, notée O_On (de l'anglais *Open_On*). L'électrode de source de chacun des transistors Q2 et Q4 est connectée à une masse électrique M, ayant un potentiel sensiblement nul.

Dans l'exemple de la figure 5, pour la génération du signal de commande du transistor de puissance 66 en mode bloqué, le deuxième sous-ensemble de transistors 92 comporte trois transistors principaux de commande 100, à savoir les transistors Q5, Q5' et Q6 dont l'électrode de drain est reliée à l'électrode de grille G du transistor de puissance 66. L'électrode de drain du transistor Q5 est reliée à l'électrode de grille G du transistor de puissance 66 via la première impédance 94, également notée R5, l'électrode de drain du transistor Q5' est reliée à l'électrode de grille G du transistor de puissance 66 via la deuxième impédance 96, également notée R5', les première et deuxième impédances 94, 96, étant reliées à l'électrode de grille G du transistor de puissance 66 via une diode D1 connectée en inverse, afin d'autoriser la circulation d'un courant seulement depuis l'électrode de grille G, en direction de la première 94 ou de la deuxième 96 impédance en fonction du transistor qui sera piloté en mode passant parmi le transistor Q5 et le transistor Q5'.

Dans l'exemple de la figure 5, le deuxième sous-ensemble de transistors 92 comporte trois transistors secondaires de commande 102, à savoir les transistors Q7, Q8 et Q9, l'électrode de drain de chacun des transistors Q7 et Q8 étant directement connectée à l'électrode de grille du transistor Q6. L'électrode de drain du transistor Q9 est quant à elle directement connectée à l'électrode de grille du transistor Q7.

Dans l'exemple de la figure 5, pour la génération du signal de commande du transistor de puissance 66 en mode bloqué, l'étage de commande 80 comporte en outre une résistance R6 connectée entre les électrodes de drain et de source du transistor Q7 et une résistance R7 connectée entre les électrodes de grille et de source du transistor Q7, et une résistance R8 connectée entre les électrodes de grille et de source du transistor Q8. L'électrode de source de chacun des transistors Q5 et Q5' est connectée à l'électrode de source S du transistor de puissance 66 correspondant via une résistance d'équilibrage R_{S}. Cette résistance d'équilibrage R_{S} permet notamment d'équilibrer la commande des transistors de puissance 66 lorsqu'au moins deux transistors de puissance 66 sont commandés en parallèle l'un de l'autre.

L'électrode de grille du transistor Q5 étant connectée à une borne de sortie 84 de l'unité de pilotage 82, notée C_Off (de l'anglais *Close_Off*), et l'électrode de grille du transistor Q5' étant connectée à une autre borne de sortie 84 de l'unité de pilotage 82, notée C_Emcy (de l'anglais *Close_Emergency*). L'électrode de grille du transistor Q8 est connectée à une borne de sortie 84 de l'unité de pilotage 82, notée C_Lock (de l'anglais *Close_Lock*), et l'électrode de grille du transistor Q9 est connectée à une autre borne de sortie 84 de l'unité de pilotage 82, notée O_Lock (de l'anglais *Open_Lock*). L'électrode de source du transistor Q6 est connectée à un potentiel négatif, noté V-, par exemple sensiblement égal à -6V. L'électrode de source de chacun des transistors Q8 et Q9 est connectée à un potentiel positif, noté Vcc, de valeur plus faible que celle du potentiel V+, le potentiel Vcc étant par exemple sensiblement égal à 3,3V.

Chaque transistor de commande 88 est de préférence un transistor à effet de champ à grille isolée, également appelé MOSFET (de l'anglais de *Metal Oxide Semiconductor Field Effect Transistor*). Autrement dit, l'ensemble 86 de transistors de commande 88 est alors constitué de transistors à effet de champ à grille isolée.

Dans l'exemple de la figure 4, les transistors Q1 et Q3 sont des MOSFET de type P, et les transistors Q2 et Q4 sont des MOSFET de type N. Dans l'exemple de la figure 5, les transistors Q5, Q5', Q6 et Q7 sont des MOSFET de type N, et les transistors Q8 et Q9 sont des MOSFET de type P.

Le fonctionnement du convertisseur d'énergie électrique 30 selon l'invention va être à présent expliqué, en particulier la commande de transistor de puissance 66 via le module de commande 50.

La commande du transistor de puissance 66 consiste, comme connu en soi, à contrôler la tension V_{GS} entre son électrode de grille G et son électrode de source S.

Lorsque les transistors de commande Q1, Q2, Q3 et Q4 sont initialement ouverts, c'est-à-dire en mode bloqué, la commande du transistor de puissance 66 en mode passant est obtenue en commandant la fermeture du transistor Q2, c'est-à-dire en commandant la commutation de son mode bloqué à son mode passant. Cette fermeture du transistor Q2 est commandée via l'émission d'un ordre correspondant de la part de l'unité de pilotage 82 sur sa borne de sortie 84, notée C_On. Cette fermeture du transistor Q2 fait alors apparaitre un potentiel sur l'électrode de grille du transistor Q1, correspondant au pont diviseur de R2 et R3 entre la masse M et le potentiel V+, ce qui a pour effet de commander la fermeture du transistor Q1, et donc de mettre l'électrode de grille G du transistor de puissance 66 au potentiel V+. Le transistor de puissance 66 est alors en mode passant.

L'homme du métier observera que, pour la commande du transistor de puissance 66 en mode passant, les transistors de commande Q3 et Q4 restent ouverts.

Lorsque l'unité de pilotage 82 souhaite commander la commutation du transistor de puissance 66 de son mode passant vers son module bloqué, elle émet un ordre d'ouverture du transistor Q2 et un ordre de fermeture du transistor Q4 sur sa borne de sortie 84, notée O_On.

La fermeture du transistor Q4 entraine alors la fermeture du transistor Q3. La fermeture du transistor Q3 provoque alors le court-circuit, ou shunt, de la résistance R3 ce qui provoque l'ouverture du transistor principal Q1 et l'électrode de grille G du transistor de puissance 66 n'est alors plus au potentiel V+. A l'issue de cette courte séquence, l'unité de pilotage 82 émet un ordre d'ouverture du transistor Q4 sur sa borne de sortie 84, notée O_On. L'ouverture du transistor Q4 entraine alors l'ouverture du transistor Q3. L'ouverture du transistor Q3 interrompt alors le court-circuit, ou shunt, de la résistance R3ce qui permet de stabiliser la déconnexion de l'électrode de grille G du transistor de puissance 66 par rapport au potentiel V+. La commutation du transistor de puissance 66 de son mode passant vers son module bloqué résulte ainsi d'une commande impulsionnelle, visible sur la figure 6, en fermeture du transistor Q4 de la part de l'unité de pilotage 82.

La résistance R3 est de préférence choisie avec une valeur élevée, telle qu'une valeur supérieure à 10kΩ, ce qui permet d'avoir une consommation électrique limitée de de l'étage de commande 80 lors de l'état passant du transistor Q2.

La résistance R4 a par exemple une valeur comprise entre 1kΩ et 5kΩ, la résistance R2 est de préférence choisie avec une faible valeur, telle qu'une valeur inférieure à 1kΩ.

Le fait de commander le transistor Q4 de manière impulsionnelle permet également de réduire la consommation électrique de l'étage de commande 80.

La séquence de blocage du transistor de puissance 66 consiste alors à amener la tension V_{GS} de la valeur positive V+ et supérieure à une valeur seuil V_{GS_th} à une valeur inférieure à ce seuil V_{GS_th}.

Lors du blocage du transistor de puissance 66, si l'unité de pilotage 82 ne détecte pas de dysfonctionnement ou défaut particulier pour transistor de puissance 66, elle émet un ordre de fermeture du transistor Q5 sur sa borne de sortie 84, notée C_Off, ce qui permet l'évacuation du courant issu de l'électrode de grille G du transistor de puissance 66 à travers la première impédance 94, également notée R5, comme représenté à la figure 7 par l'état intermédiaire du transistor de puissance 66 après la flèche F1. Sur la figure 7, le chemin de circulation du courant est illustré par un trait gras et épais, notamment l'évacuation du courant issu de l'électrode de grille G vers la masse M, dans l'état intermédiaire du transistor de puissance 66 après la flèche F1.

Après une période temporelle prédéfinie, correspondant au temps nécessaire à l'évacuation du courant issu de l'électrode de grille G du transistor de puissance 66 à travers la première impédance 94, l'unité de pilotage 82 commande la fermeture du transistor Q6 afin de mettre l'électrode de grille G du transistor de puissance 66 au potentiel V- inférieur à la valeur seuil V_{GS_th}, comme représenté en trait gras et épais à la figure 7 par l'état final du transistor de puissance 66 après la flèche F2. Cette fermeture du transistor Q6 est commandée via l'émission d'ordres correspondants de la part de l'unité de pilotage 82 sur ses bornes de sortie 84, notées C_Lock et O_Lock, à destination des électrodes de grille des transistors Q8 et Q9.

Lors du blocage du transistor de puissance 66, si l'unité de pilotage 82 détecte un dysfonctionnement ou un défaut du transistor de puissance 66, par exemple une surtension entre les électrodes de drain D et de source S ou encore un court-circuit entre les électrodes de grille G et de source S du transistor de puissance 66, l'unité de pilotage 82 émet un ordre de fermeture du transistor Q5' sur sa borne de sortie 84, notée C_Emcy, ce qui permet l'évacuation du courant issu de l'électrode de grille G du transistor de puissance 66 à travers la deuxième impédance 94, également notée R5', comme représenté à la figure 8 par l'état intermédiaire du transistor de puissance 66 après la flèche F3. Sur la figure 8, le chemin de circulation du courant est également illustré par un trait gras et épais, notamment l'évacuation du courant issu de l'électrode de grille G vers la masse M, dans l'état intermédiaire du transistor de puissance 66 après la flèche F3.

L'homme du métier observera alors que, comme la deuxième impédance 96 est de valeur supérieure à celle de la première impédance 94, la valeur de la résistance R5' étant par exemple le double de la valeur de la résistance R5, et notamment entre 8 fois et 30 fois supérieure, cela permet alors une coupure plus lente du transistor de puissance 66 et une évacuation plus lente du courant issu de l'électrode de grille G du transistor de puissance 66, ceci afin de protéger davantage le transistor de puissance 66 en cas de détection d'un dysfonctionnement de celui-ci.

Autrement dit, lors de la commutation du transistor de puissance 66 de son mode passant vers son mode bloqué, l'évacuation du courant issu de l'électrode de grille G du transistor de puissance 66 est effectuée soit à travers la première impédance 94 en cas de fonctionnement normal du transistor de puissance 66, soit à travers la deuxième impédance 96 en cas de dysfonctionnement du transistor de puissance 66.

En outre, en cas de dysfonctionnement du transistor de puissance 66, correspondant par exemple à un court-circuit entre les électrodes de grille G et de source S du transistor de puissance 66, l'unité de pilotage 82 maintient l'électrode de grille G du transistor de puissance 66 à la masse électrique M, comme représenté en trait gras et épais à la figure 8, via la résistance R5' et la fermeture du transistor Q5', et ne met alors avantageusement pas l'électrode de grille G du transistor de puissance 66 au potentiel V-via une fermeture du transistor Q6, ceci afin de ne pas solliciter les transistors de commande Q6 à Q9 et de ne pas risquer un endommagement de ces transistors de commande Q6 à Q9 du fait du court-circuit précité. Ceci permet également d'éviter une surconsommation électrique de la part des transistors de commande Q6 à Q9 dans ce cas.

Ainsi, chaque étage de commande 80 est de préférence réalisé à partir de la technologie MOS, chaque transistor de commande 88 étant de préférence un transistor à effet de champ à grille isolée, ce qui présente l'avantage de ne pas exiger une consommation permanente de courant pour se maintenir dans un état donné, contrairement aux technologies nécessitant une source de courant, telle que la technologie à transistors bipolaires par exemple.

En outre, la connexion directe des bornes de sortie 84 de l'unité de pilotage 82, par exemple réalisée sous forme d'un composant logique programmable, tel qu'un FPGA, aux électrodes de grille des transistors de commande 88 correspondants, en particulier aux électrodes de grille des transistors Q2, Q4, Q5, Q5', Q8 et Q9, permet de transmettre les ordres de manière rapide, sans consommation statique.

Lorsque les transistors de puissance 66 sont des transistors réalisés en carbure de silicium, leur commutation est bien plus rapide, ce qui permet d'améliorer encore le fonctionnement du convertisseur d'énergie électrique 30 selon l'invention.

À titre d'exemple, la commutation d'un transistor de puissance 66 réalisé en carbure de silicium s'effectue généralement dans un délai compris entre 70 et 100 ns, et est environ 5 à 10 fois plus rapide que celle d'un transistor de puissance réalisé en silicium qui s'effectue généralement dans un délai de l'ordre de 500 ns à 1 µs.

Cette réduction de consommation électrique permet aussi une implantation plus aisée des différents composants : des pertes réduites permettent de réduire la taille et le nombre de composants à implanter. Cette réduction de consommation électrique offre notamment la possibilité de disposer chaque étage de commande 80, faible consommateur en énergie électrique et donc faible dissipateur en énergie thermique, au plus près de chaque transistor de puissance 66, ce qui est particulièrement important lorsque le transistor de puissance 66 est réalisé en carbure de silicium.

En complément, l'homme du métier observera qu'en matière de consommation électrique d'un tel convertisseur d'énergie électrique 30, deux consommations électriques sont à prendre en considération. Une première consommation électrique est la consommation de chaque bras de commutation 40 lors de sa commutation, dont l'ordre de grandeur exprimé en RMS est en général au-dessus du kW. Une deuxième consommation électrique est la consommation de chaque module de commande 50 lui-même, qui est quant à elle généralement inférieure à 5W au global, ce qui est sans commune mesure avec la première consommation électrique. Mais ce n'en n'est pas moins important, car cela dimensionne l'alimentation du module de commande 50. Le convertisseur d'énergie électrique 30 selon l'invention permet alors de réduire chacune de ces première et deuxième consommations électriques.

La réduction de la deuxième consommation électrique a été explicitée en détail précédemment, et l'homme du métier comprendra en outre que le convertisseur d'énergie électrique 30 selon l'invention permet également d'offrir une commande plus précise de l'électrode de grille G de chacun des transistors de puissance 66, ce qui a pour effet de réduire des conductions parasites qui impactent les pertes en kW du convertisseur d'énergie électrique 30. La première consommation électrique est alors également réduite.

On conçoit ainsi que le convertisseur d'énergie électrique 30 selon l'invention permet d'améliorer la commutation au sein de chaque bras de commutation 40, en limitant la consommation d'énergie électrique pour cette commutation.

## Revendications

1. Convertisseur d'énergie électrique (30) configuré pour convertir une première énergie électrique en une deuxième énergie électrique, comprenant :
- deux premières bornes (36) associées à la première énergie électrique ;
- au moins une deuxième borne (38) associée à la deuxième énergie électrique ;
- au moins un bras de commutation (40), chaque bras de commutation (40) comportant deux demi-bras de commutation (42) connectés en série entre les deux premières bornes (36) et reliés entre eux en un point intermédiaire (44), le point intermédiaire (44) étant relié à une deuxième borne (38) respective, chaque demi-bras de commutation (42) comportant au moins un interrupteur (48), chaque interrupteur (48) comportant au moins un transistor de puissance (66) réalisé en carbure de silicium, et
- deux modules de commande (50), chaque module de commande (50) étant configuré pour commander le ou les interrupteurs (48) d'un demi-bras de commutation (42) respectif, chaque module de commande (50) comportant un étage de commande (80) connecté à une électrode de grille (72, G) de chaque transistor de puissance (66) compris dans le demi-bras de commutation correspondant,
le ou chaque étage de commande (80) comportant un ensemble (86) de transistors de commande (88) configuré pour commander le ou au moins l'un des transistors de puissance (66) auquel l'étage de commande est connecté parmi un mode passant et un mode bloqué,
l'ensemble (86) de transistors de commande (88) comportant un transistor principal de commande (100) relié à l'électrode de grille (72, G) du transistor de puissance (66) et au moins un transistor secondaire de commande (102) relié à une électrode de grille du transistor principal de commande (100),
au moins un transistor de l'ensemble (86) de transistors de commande (88) étant un transistor à effet de champ à grille isolée,
**caractérisé en ce que** chaque module de commande (50) comporte une unité de pilotage (82) configurée pour piloter l'étage de commande (80), l'unité de pilotage (82) étant configurée pour maintenir l'électrode de grille (G) du transistor de puissance (66) à la masse électrique (M) via une résistance (R5') et la fermeture d'un transistor (Q5') en cas de dysfonctionnement du transistor de puissance (66).

2. Convertisseur d'énergie électrique (30) selon la revendication 1, dans lequel l'ensemble (86) de transistors de commande (88) est constitué de transistors à effet de champ à grille isolée.

3. Convertisseur d'énergie électrique (30) selon la revendication 1 ou 2, dans lequel l'ensemble (86) de transistors de commande (88) comporte un premier sous-ensemble de transistors (90) pour la génération d'un signal de commande du transistor de puissance (66) en mode passant et un deuxième sous-ensemble de transistors (92) pour la génération d'un signal de commande du transistor de puissance (66) en mode bloqué,
chaque sous-ensemble de transistors (90, 92) comportant un transistor principal de commande (100) relié à une électrode de grille (72, G) du transistor de puissance (66) et au moins un transistor secondaire de commande (102) relié à une électrode de grille du transistor principal de commande (100).

4. Convertisseur d'énergie électrique (30) selon l'une quelconque des revendications précédentes, dans lequel l'étage de commande (80) comporte en outre des première (94) et deuxième (96) impédances, la deuxième impédance (96) étant distincte de la première impédance (94) et de valeur supérieure à celle de la première impédance (94), et
dans lequel l'ensemble (86) de transistors de commande (88) est configuré pour commuter entre une première configuration d'extinction du transistor de puissance (66) dans laquelle un courant issu de l'électrode de grille (72, G) du transistor de puissance (66) circule à travers la première impédance (94) lors de la commande du transistor de puissance (66) en mode bloqué et une deuxième configuration d'extinction du transistor de puissance (66) dans laquelle un courant issu de l'électrode de grille (72, G) du transistor de puissance (66) circule à travers la deuxième impédance (96) lors de la commande du transistor de puissance (66) en mode bloqué.

5. Convertisseur d'énergie électrique (30) selon l'une quelconque des revendications précédentes, dans lequel l'unité de pilotage (82) est réalisée sous forme d'un composant logique programmable, tel qu'un FPGA.

6. Convertisseur d'énergie électrique (30) selon l'une quelconque des revendications précédentes, dans lequel chaque interrupteur (48) est un interrupteur bidirectionnel comportant une diode (68) connectée en antiparallèle de chaque transistor de puissance (66), chaque transistor de puissance (66) étant réalisé en carbure de silicium (SiC).

7. Convertisseur d'énergie électrique (30) selon l'une quelconque des revendications précédentes, dans lequel chaque demi-bras de commutation (42) comporte N demi-branches de commutation (46) connectées en parallèle, N étant un nombre entier supérieur ou égal à 2, chaque demi-branche de commutation (46) comportant au moins un interrupteur (48).

8. Convertisseur d'énergie électrique (30) selon l'une quelconque des revendications précédentes, dans lequel le convertisseur d'énergie électrique (30) comprend P bras de commutation (40) et 2xP modules de commande (50), P étant un nombre entier supérieur ou égal à 2, de préférence égal à 3.

9. Chaîne de traction (12) pour un véhicule électrique de transport (10), la chaîne de traction (12) comprenant un moteur électrique (26) et un convertisseur d'énergie électrique (30) relié au moteur électrique (26),
**caractérisé en ce que** le convertisseur d'énergie électrique (30) est selon l'une quelconque des revendications précédentes.

10. Véhicule électrique de transport (10), tel qu'un véhicule ferroviaire, comprenant une chaîne de traction (12) configurée pour provoquer un déplacement du véhicule (10),
**caractérisé en ce que** la chaîne de traction (12) est selon la revendication précédente.
